# EUROPEAN PATENT APPLICATION

(11) **EP 4 141 913 A1**
(43) Date of publication of application: **01.03.2023**
(21) Application number: 22192268.5
(22) Date of filing: 26.08.2022
(51) Int. Cl.: H01L 21/336, H01L 29/08, H01L 21/265, H01L 29/167, H01L 29/78

(54) **NMOS DEVICE, PRODUCTION METHOD THEREOF, AND INTEGRATED CIRCUIT**

(30) Priority: 28.08.2021 CN 202110999007
(71) Applicant: Huawei Technologies Co., Ltd., Shenzhen, Guangdong 518129 (CN)
(72) Inventor: TANG, Fengjie, SHENZHEN, 518129 (CN)
(74) Representative: Körber, Martin Hans

(57) **Abstract**

This application discloses an NMOS device, a production method thereof, and an integrated circuit. The NMOS device includes a semiconductor substrate, a gate oxide layer, and a gate. The semiconductor substrate includes a P well, a source region, a drain region, a first LDD region, and a second LDD region. The first LDD region and the second LDD region each include a first ion injection region and a second ion injection region. The first ion injection region is formed by injecting a first ion, and the first ion includes a P ion. The second ion injection region is formed by injecting a second ion into the first ion injection region, and the second ion includes a Ge ion. A Ge atom is relatively large, a defect may be generated, to help diffuse the first ion, so that a transverse electric field can be reduced, and an HCI effect can be improved. In addition, because the Ge atom is relatively large, a probability that a carrier collides with the Ge atom increases, so that an impact ionization rate can be reduced, a quantity of high-energy carriers can be reduced, and the HCI effect can be further improved.

## Description

### TECHNICAL FIELD

This application relates to the field of semiconductor technologies, and in particular, to an NMOS device, a production method thereof, and an integrated circuit.

### BACKGROUND

A device size of an integrated circuit is continuously miniaturized with development of a process. However, poor reliability caused due to miniaturization becomes increasingly severe while performance is improved and power consumption is reduced. Strength of a transverse electric field of a channel of a device increases as a size of the device is continuously reduced, especially an electric field near a drain is the strongest. When a feature size of the device is reduced to a submicron level, a hot carrier injection (Hot Carrier Inject, HCI) effect may occur near the drain.

The HCI effect means accelerating movement of a carrier under an action of a high electric field, to convert the carrier into a hot carrier with high energy. When the energy of the hot carrier exceeds a barrier height between a channel and an interface of a gate oxide layer, the hot carrier can be directly injected into or enter the gate oxide layer by using a tunneling effect. In this case, parameters such as a threshold voltage Vth and linear-region transconductance gm of an N-channel metal oxide semiconductor (Negative channel Metal Oxide Semiconductor, NMOS) device is drifted or degraded. Consequently, reliability of the device is affected, and finally, a circuit fails.

### SUMMARY

This application provides an NMOS device, a production method thereof, and an integrated circuit, to improve a hot carrier injection effect of the NMOS device.

According to a first aspect, this application provides an NMOS device, where the NMOS device includes a semiconductor substrate, a gate oxide layer located on the semiconductor substrate, and a gate located at the gate oxide layer. The semiconductor substrate includes a P well, and a source region, a drain region, a first lightly doped drain (Lightly Doped Drain, LDD) region, and a second LDD region that are located in the P well. The first LDD region is located between the source region and the drain region, and a distance between the first LDD region and the source region is less than a distance between the first LDD region and the drain region. The second LDD region is located between the source region and the drain region, and a distance between the second LDD region and the drain region is less than a distance between the second LDD region and the source region. The first LDD region and the second LDD region each include a first ion injection region and a second ion injection region. The first ion injection region is formed by injecting a first ion into the P well. The first ion may include a phosphorus (P) ion. The second ion injection region is formed by injecting a second ion into a shallow region of the first ion injection region. In other words, an ion injection depth of the second ion injection region is less than an ion injection depth of the first ion injection region. The second ion may include a germanium (Ge) ion.

In this application, because the second ion injected into the second ion injection region is the Ge ion, and an atom of the Ge ion is relatively large, a defect may be generated, to help diffuse the first ion, so that a junction depth becomes deeper and is slowed down, a transverse electric field can be reduced, and an HCI effect can be improved. In addition, the Ge atom may occupy a location of a silicon lattice. Moreover, because the Ge atom is relatively large, a probability that a carrier collides with the Ge atom increases, a mean free path of the carrier decreases, and an energy of the carrier decreases, so that an impact ionization rate can be reduced, a quantity of high-energy carriers can be reduced, and the HCI effect can be further improved.

In this application, the first LDD region and the second LDD region are located between the source region and the drain region, and doping densities of the first LDD region and the second LDD region are less than doping densities of the source region and the drain region. The LDD region is disposed, so that a density gradient at a location at which a channel is bonded to each of the drain region and the source region can be reduced, and electric field strength of the source region and the drain region can be reduced to a degree, to suppress the HCI effect.

It should be noted that, in this application, the ion injection depth is a depth at which an ion is diffused from a surface of the P well to the inside of the P well.

The ion injection depths of the first ion injection region and the second ion injection region are not limited in this application, provided that it is ensured that the second ion injection region is formed by injecting the second ion into the shallow region of the first ion injection region. For example, the ion injection depth of the second ion injection region may be set between 5 nm and 100 nm.

In a specific implementation, a low injection density of the second ion causes a poor improvement effect, and a high injection density thereof causes occupation of a large quantity of locations of Si. For example, an ion injection density of the second ion may be controlled to be 1e14 ions/cm² to 1e15 ions/cm². This is not limited in this application.

For example, in this application, the first ion may further include an arsenic (As) ion. This is not limited herein.

Optionally, in this application, the source region and the drain region may be formed by injecting ions into the semiconductor substrate, and the ion injected into the source region and the drain region is an N-type ion, for example, a +5 valence ion such as a P ion or an As ion. The source region and the drain region are heavily doped regions relative to the first LDD region and the second LDD region. For example, ion injection densities of the source region and the drain region are one to two orders of magnitude greater than ion injection densities of the first LDD region and the second LDD region.

For example, ion injection depths of the source region and the drain region may be greater than the ion injection depths of the first LDD region and the second LDD region, or ion injection depths of the source region and the drain region may be less than the ion injection depths of the first LDD region and the second LDD region.

For example, to further improve an improvement effect, in the first LDD region, a side of the second ion injection region that faces the drain region extends towards the drain region relative to a side of the first ion injection region that faces the drain region; and in the second LDD region, a side of the second ion injection region that faces the source region extends towards the source region relative to a side of the first ion injection region that faces the source region.

Optionally, in the first LDD region, a distance between the side of the second ion injection region that faces the drain region and the side of the first ion injection region that faces the drain region may be set between 0 nm and 25 nm; and in the second LDD region, a distance between the side of the second ion injection region that faces the source region and the side of the first ion injection region that faces the source region may be set between 0 nm and 25 nm.

Optionally, the NMOS device may further include a side wall located on side walls of the gate and the gate oxide layer. The side wall may be formed by using at least one material such as silicon oxide or silicon nitride. This is not limited herein.

According to a second aspect, this application provides an integrated circuit, including a main board and the NMOS device that is disposed on the main board and that is according to the first aspect or various implementations of the first aspect. For a technical effect that may be achieved in the second aspect, refer to the descriptions of the technical effect that may be achieved in any possible design in the foregoing first aspect. Details are not described herein again.

According to a third aspect, this application provides a production method of an NMOS device, where the method may include the following steps: providing a semiconductor substrate, where the semiconductor substrate has a P well; forming a gate oxide layer on the P well; forming a gate at the gate oxide layer; and forming a source region, a drain region, a first lightly doped drain region, and a second lightly doped drain region in the P well. The first LDD region is located between the source region and the drain region, and a distance between the first LDD region and the source region is less than a distance between the first LDD region and the drain region. The second LDD region is located between the source region and the drain region, and a distance between the second LDD region and the drain region is less than a distance between the second LDD region and the source region. The first lightly doped drain region and the second lightly doped drain region each include a first ion injection region and a second ion injection region. The first ion injection region is formed by injecting a first ion into the semiconductor substrate. The first ion includes a P ion or a P ion and an As ion. The second ion injection region is formed by injecting a second ion into the first ion injection region. The second ion includes a Ge ion. An ion injection depth of the first ion injection region is greater than an ion injection depth of the second ion injection region.

In this application, the forming a first lightly doped drain region and a second lightly doped drain region in the P well may include: injecting the P ion or the P ion and the As ion into the P well to form the first ion injection region of the first LDD region and the first ion injection region of the second LDD region, that is, the first ion injection region of the first LDD region and the first ion injection region of the second LDD region are simultaneously formed; and injecting the Ge ion into the first ion injection region of the first LDD region to form the second ion injection region of the first LDD region, and injecting the Ge ion into the first ion injection region of the second LDD region to form the second ion injection region of the second LDD region, that is, the second ion injection region of the first LDD region and the second ion injection region of the second LDD region are simultaneously formed. Because the second ion is injected after the first ion is injected, and a same photomask is used to inject the first ion and the second ion, no additional photomask needs to be added. In addition, after the second ion is injected, an ion activation and diffusion process is simultaneously performed on the first ion injection region and the second ion injection region, and no additional ion activation and diffusion process needs to be added for the second ion. Therefore, a process procedure is simpler and costs are lower.

The ion injection depths of the first ion injection region and the second ion injection region are not limited in this application, provided that it is ensured that the second ion injection region is formed by injecting the second ion into a shallow region of the first ion injection region. For example, the ion injection depth of the second ion injection region may be set between 5 nm and 100 nm.

In a specific implementation, low injection energy of the second ion causes a shallow depth of an injection region, and high injection energy causes serious damage to Si in the semiconductor substrate. For example, injection energy of the second ion may be controlled to be 10 kev to 60 kev.

In a specific implementation, a low injection density of the second ion causes a poor improvement effect, and a high injection density thereof causes occupation of a large quantity of locations of Si. For example, an ion injection density of the second ion may be controlled to be 1e14 ions/cm² to 1e15 ions/cm². This is not limited in this application.

In this application, because Ge and Si are homogeneous intrinsic elements, and an injection dosage and injection energy of Ge are not large, a relatively small impact is exerted on an initial electrical characteristic of the NMOS device.

During production, an angle between an injection direction of the second ion and a normal of the semiconductor substrate is greater than 0 degrees, so that in the first LDD region, a side of the second ion injection region that faces the drain region extends towards the drain region relative to a side of the first ion injection region that faces the drain region; and in the second LDD region, a side of the second ion injection region that faces the source region extends towards the source region relative to a side of the first ion injection region that faces the source region.

Optionally, in the first LDD region, a distance between the side of the second ion injection region that faces the drain region and the side of the first ion injection region that faces the drain region may be set between 0 nm and 25 nm; and in the second LDD region, a distance between the side of the second ion injection region that faces the source region and the side of the first ion injection region that faces the source region may be set between 0 nm and 25 nm.

For example, the angle between the injection direction of the second ion and the normal of the semiconductor substrate is set to be greater than or equal to 10 degrees and less than or equal to 60 degrees.

### BRIEF DESCRIPTION OF DRAWINGS

FIG. 1 is a schematic diagram of a structure of an NMOS device in a related technology;
FIG. 2 is a schematic diagram of a structure of an NMOS device according to an embodiment of this application;
FIG. 3 is a flowchart of a production method of an NMOS device according to an embodiment of this application;
FIG. 4 is a schematic diagram of a structure of an NMOS device according to another embodiment of this application;
FIG. 5 is a schematic diagram of a structure of an NMOS device according to another embodiment of this application;
FIG. 6 is a flowchart of a production method of an NMOS device according to another embodiment of this application; and
FIG. 7a to FIG. 7i are schematic diagrams of structures of a production process of an NMOS device according to an embodiment of this application.

### DESCRIPTION OF EMBODIMENTS

To make objectives, technical solutions, and advantages of this application clearer, the following further describes this application in detail with reference to accompanying drawings.

It should be noted that, in this specification, similar reference numerals and letters represent similar items in the following accompanying drawings. Therefore, once an item is defined in one of the accompanying drawings, no further definition or explanation is required in the subsequent accompanying drawings.

In the descriptions of this application, it should be noted that, directions or location relationships indicated by terms such as "center", "up", "down", "left", "right", "vertical", "horizontal", "inside", and "outside" are based on the directions or location relationships shown in the accompanying drawings, and are merely intended to describe this application and simplify the descriptions, but are not intended to indicate or imply that an indicated apparatus or element needs to have a specific direction or be constructed and operated in a specific direction, and therefore cannot be understood as a limitation on this application. Expressions of locations and directions described in this application are all described by using the accompanying drawings as an example, but changes may be made as required, and the changes fall within the protection scope of the present invention. The accompanying drawings of this application are merely used to illustrate a relative location relationship and do not represent a true proportion. In addition, the terms "first" and "second" are used only for the purpose of description, and cannot be understood as an indication or implication of relative importance.

In the descriptions of this application, it should be noted that, unless otherwise specified or limited, terms "mount", "communicate", and "connect" should be understood in a broad sense, for example, may be a fixed connection, a detachable connection, or an integrated connection, may be a mechanical connection or an electrical connection, may be a direct connection or an indirect connection by using an intermediate medium, or may be a connection between the inside of two elements. For a person of ordinary skill in the art, specific meanings of the foregoing terms in this application may be understood based on a specific case.

An NMOS device provided in embodiments of this application serves as a component of an integrated circuit, and is widely used in various scenarios, for example, may be used in an integrated circuit having various functions such as logic, storage (such as Flash and DRAM), simulation, and sensing. Certainly, the NMOS device in the embodiments of this application may be used in another type of integrated circuit. Examples are not illustrated one by one herein.

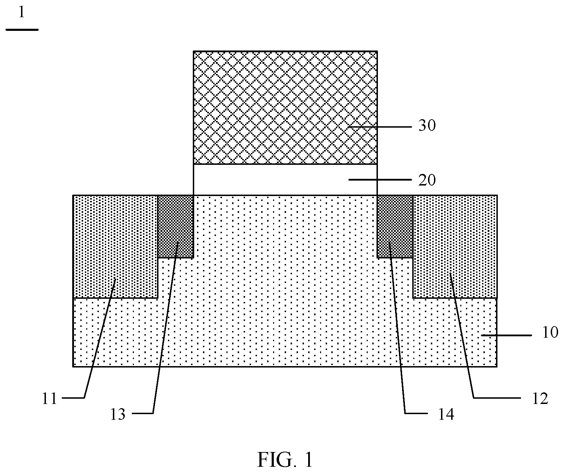

As a process size of the NMOS device can be continuously reduced, electric field crowding (Electric Field Crowding) at a drain end may cause an HCI effect. In a related technology, to suppress the HCI effect, an LDD region is disposed between an end of a channel and each of a source and the drain. As shown in FIG. 1, a conventional NMOS device 1 having an LDD structure includes a semiconductor substrate 10, a gate oxide layer 20 located on the semiconductor substrate 10, and a gate 30 located at the gate oxide layer 20. The semiconductor substrate 10 includes a source region 11, a drain region 12, a first LDD region 13, and a second LDD region 14. The first LDD region 13 is located between the source region 11 and the drain region 12, and is close to the source region 11. The second LDD region 14 is located between the source region 11 and the drain region 12, and is close to the drain region 12. A channel exists between the first LDD region 13 and the second LDD region 14.

The LDD structure is disposed, so that a density gradient at a location at which the channel is bonded to each of the drain and the source can be reduced, and electric field strength of the source and drain can be reduced to a degree, to suppress the HCI effect. However, with miniaturization in a process, a junction depth becomes shallow, an existing LDD structure cannot effectively reduce a high electric field in the drain region, and the HCI effect of the NMOS device is serious. Consequently, reliability of the NMOS device is relatively poor.

Based on this, this application provides an NMOS device for improving an HCI effect and a production method thereof, to resolve poor reliability of the NMOS device caused by the HCI effect. To facilitate understanding of the technical solutions of this application, with reference to the accompanying drawings and specific implementations, the following specifically describes the NMOS device and the production method thereof provided in this application.

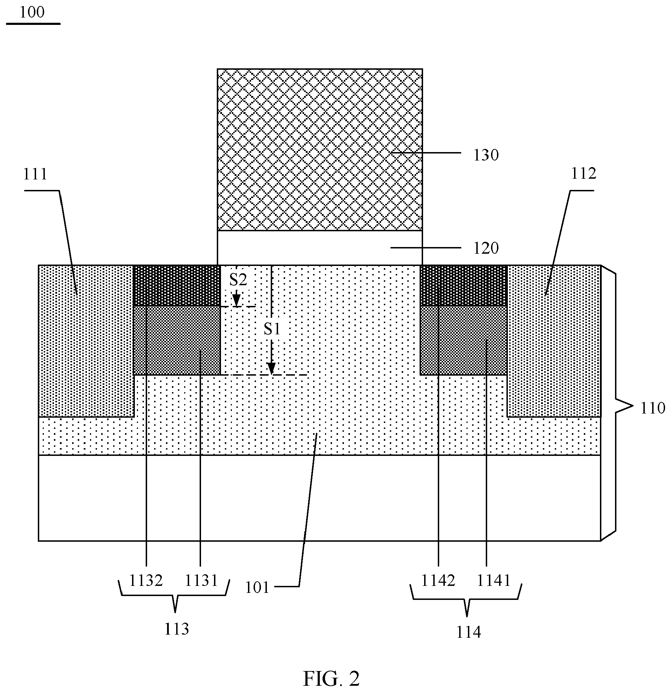

FIG. 2 is a schematic diagram of a structure of an NMOS device according to an embodiment of this application. An NMOS device 100 provided in this embodiment of this application may include a semiconductor substrate 110, a gate oxide layer 120 located on the semiconductor substrate 110, and a gate 130 located at the gate oxide layer 120. The semiconductor substrate 110 includes a P well 101, and a source region 111, a drain region 112, a first LDD region 113, and a second LDD region 114 that are located in the P well 101. The first LDD region 113 is located between the source region 111 and the drain region 112, and is close to the source region 111, that is, a distance between the first LDD region 113 and the source region 111 is less than a distance between the first LDD region 113 and the drain region 112. The second LDD region 114 is located between the source region 111 and the drain region 112, and is close to the drain region 112, that is, a distance between the second LDD region 114 and the drain region 112 is less than a distance between the second LDD region 114 and the source region 111. The first LDD region 113 includes a first ion injection region 1131 and a second ion injection region 1132, and the second LDD region 114 includes a first ion injection region 1141 and a second ion injection region 1142. The first ion injection regions 1131 and 1141 each are formed by injecting a first ion into the P well 101. The first ion may include a phosphorus (P) ion. The second ion injection regions 1132 and 1142 are formed by separately injecting a second ion into shallow regions of the first ion injection regions 1131 and 1141. In other words, ion injection depths S2 of the second ion injection regions 1132 and 1142 are less than ion injection depths S1 of the first ion injection regions 1131 and 1141. The second ion may include a germanium (Ge) ion.

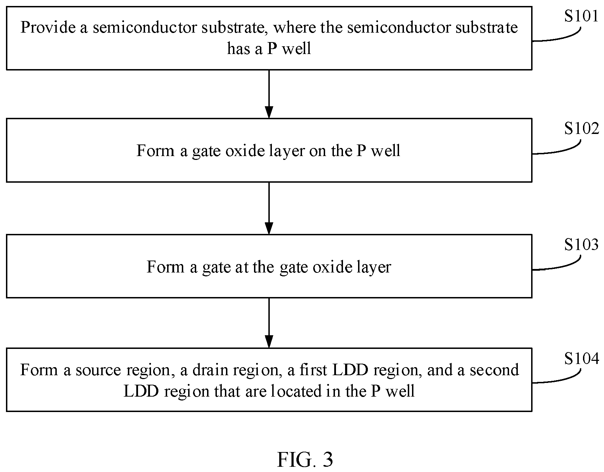

FIG. 3 is a schematic flowchart of a production method of an NMOS device according to an embodiment of this application. The production method may include the following steps:
S101: Provide a semiconductor substrate, where the semiconductor substrate has a P well.

In a specific implementation, the semiconductor substrate may be one of a silicon substrate, gallium nitride, gallium arsenide, and a silicon substrate on an insulator. The semiconductor substrate may be directly doped with a P-type ion (for example, a +3 valence ion such as boron B) to form the P well, or an N-type substrate may be doped with a P-type ion (for example, a +3 valence ion such as boron B) to form the P well.

S102: Form a gate oxide layer on the P well.

For example, the gate oxide layer may be formed by using a high-permittivity material such as silicon dioxide (SiO2).

S103: Form a gate at the gate oxide layer.

Optionally, the gate may be formed by using a polycrystalline silicon material or a metal material. This is not limited herein.

For example, the gate may be formed by depositing a polycrystalline silicon film layer at the gate oxide layer by using a chemical vapor deposition (Chemical Vapor Deposition, CVD) method.

S104: Form a source region, a drain region, a first LDD region, and a second LDD region in the P well.

Referring to FIG. 2, in the P well 101, the first LDD region 113 is located between the source region 111 and the drain region 112, and is close to the source region 111, and the second LDD region 114 is located between the source region 111 and the drain region 112, and is close to the drain region 112. The first LDD region 113 includes a first ion injection region 1131 and a second ion injection region 1132, and the second LDD region 114 includes a first ion injection region 1141 and a second ion injection region 1142. The first ion injection regions 1131 and 1141 each are formed by injecting a first ion into the P well 101. The first ion may include a phosphorus (P) ion. The second ion injection regions 1132 and 1142 are formed by separately injecting a second ion into shallow regions of the first ion injection regions 1131 and 1141. In other words, ion injection depths S2 of the second ion injection regions 1132 and 1142 are less than ion injection depths S1 of the first ion injection regions 1131 and 1141. The second ion may include a Ge ion.

For example, the first ion may further include an arsenic (As) ion, for example, the first ion is a P ion and an As ion. This is not limited herein.

It should be noted that, in this application, the ion injection depth is a depth at which an ion is diffused from a surface of the P well to the inside of the P well.

In this application, after the first ion is injected into the P well 101 to form the first ion injection regions 1131 and 1141, the second ion is injected into the shallow regions of the first ion injection regions 1131 and 1141 to form the second ion injection regions 1132 and 1142. Because the second ion injected into the second ion injection regions 1132 and 1142 is the Ge ion, and an atom of the Ge ion is relatively large, a defect may be generated, to help diffuse the first ion, so that a junction depth becomes deeper and is slowed down, a transverse electric field can be reduced, and an HCI effect can be improved. In addition, the Ge atom may occupy a location of a silicon lattice. Moreover, because the Ge atom is relatively large, a probability that a carrier collides with the Ge atom increases, a mean free path of the carrier decreases, and an energy of the carrier decreases, so that an impact ionization rate can be reduced, a quantity of high-energy carriers can be reduced, and the HCI effect can be further improved.

The ion injection depths of the first ion injection region and the second ion injection region are not limited in this application, provided that it is ensured that the second ion injection region is formed by injecting the second ion into the shallow region of the first ion injection region. For example, the ion injection depth of the second ion injection region may be set between 5 nm and 100 nm.

In a specific implementation, low injection energy of the second ion causes a shallow depth of an injection region, and high injection energy causes serious damage to Si in the semiconductor substrate. For example, injection energy of the second ion may be controlled to be 10 kev to 60 kev.

In a specific implementation, a low injection density of the second ion causes a poor improvement effect, and a high injection density thereof causes occupation of a large quantity of locations of Si. For example, an ion injection density of the second ion may be controlled to be 1e14 ions/cm² to 1e15 ions/cm². This is not limited in this application.

In this application, because Ge and Si are homogeneous intrinsic elements, and an injection dosage and injection energy of Ge are not large, a relatively small impact is exerted on an initial electrical characteristic of the NMOS device.

In this application, the forming a first LDD region and a second LDD region in the P well may include: injecting the P ion or the P ion and the As ion into the P well to form the first ion injection region of the first LDD region and the first ion injection region of the second LDD region, that is, the first ion injection region of the first LDD region and the first ion injection region of the second LDD region are simultaneously formed; injecting the Ge ion into the first ion injection region of the first LDD region to form the second ion injection region of the first LDD region, and injecting the Ge ion into the first ion injection region of the second LDD region to form the second ion injection region of the second LDD region, that is, the second ion injection region of the first LDD region and the second ion injection region of the second LDD region are simultaneously formed. Because the second ion is injected after the first ion is injected, and a same photomask is used to inject the first ion and the second ion, no additional photomask needs to be added. In addition, after the second ion is injected, an ion activation and diffusion process is simultaneously performed on the first ion injection region and the second ion injection region, and no additional ion activation and diffusion process needs to be added for the second ion. Therefore, a process procedure is simpler and costs are lower.

Optionally, in this application, the source region 111 and the drain region 112 may be formed by injecting ions into the P well 101, and the ion injected into the source region 111 and the drain region 112 is an N-type ion, for example, a +5 valence ion such as a P ion or an As ion. The source region 111 and the drain region 112 are heavily doped regions relative to the first LDD region 113 and the second LDD region 114. For example, ion injection densities of the source region 111 and the drain region 112 are one to two orders of magnitude greater than ion injection densities of the first LDD region 113 and the second LDD region 114.

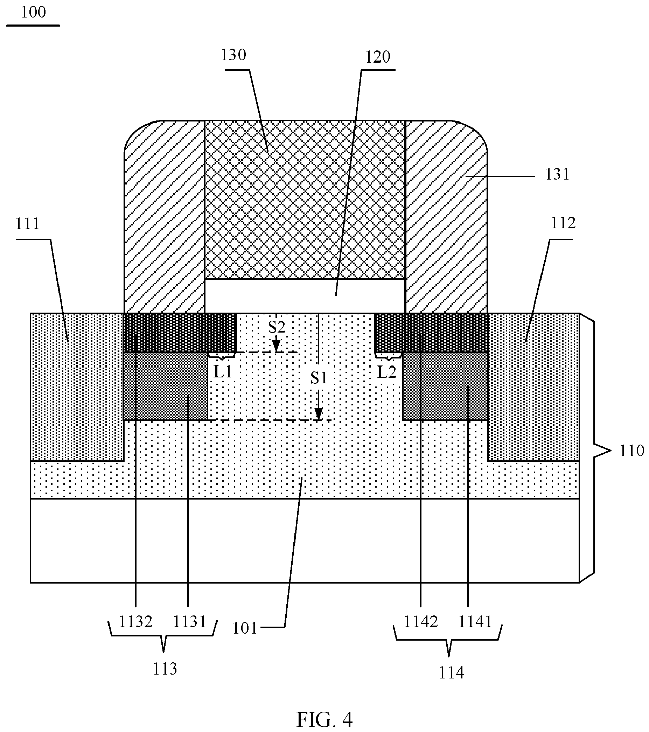

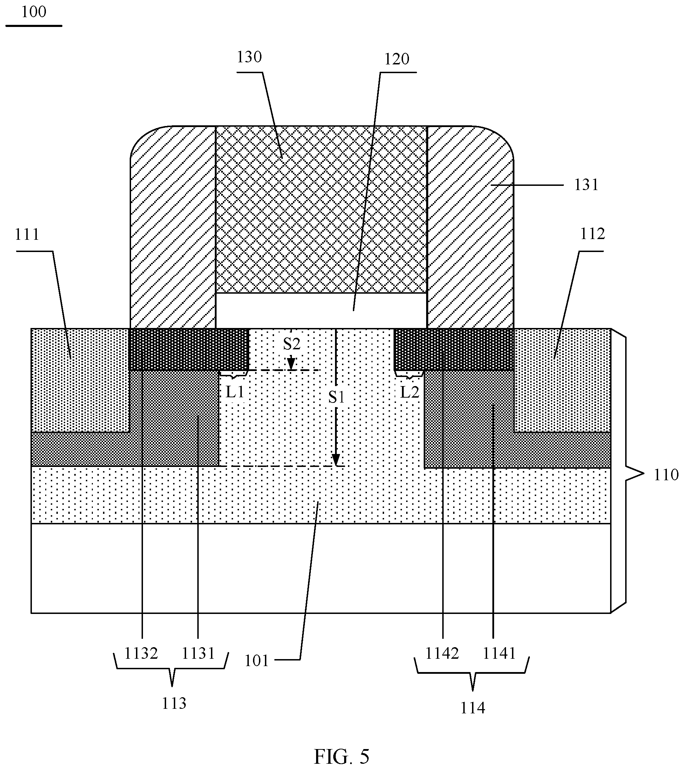

For example, as shown in FIG. 4, ion injection depths of the source region 111 and the drain region 112 may be greater than the ion injection depths of the first LDD region 113 and the second LDD region 114, or as shown in FIG. 5, ion injection depths of the source region 111 and the drain region 112 may be less than the ion injection depths of the first LDD region 113 and the second LDD region 114.

Optionally, referring to FIG. 4 and FIG. 5, the NMOS device 100 may further include a side wall 131 located on side walls of the gate 130 and the gate oxide layer 120. The side wall 131 may be formed by using at least one material such as silicon oxide or silicon nitride. This is not limited herein.

For example, to further improve an improvement effect, referring to FIG. 4 and FIG. 5, in the first LDD region 113, a side of the second ion injection region 1132 that faces the drain region 112 extends towards the drain region 112 relative to a side of the first ion injection region 1131 that faces the drain region 112; and in the second LDD region 114, a side of the second ion injection region 1142 that faces the source region 111 extends towards the source region 111 relative to a side of the first ion injection region 1141 that faces the source region 111.

Optionally, as shown in FIG. 4 and FIG. 5, in the first LDD region 113, a distance L1 between the side of the second ion injection region 1132 that faces the drain region 112 and the side of the first ion injection region 1131 that faces the drain region 112 may be set between 0 nm and 25 nm; and in the second LDD region 114, a distance L2 between the side of the second ion injection region 1142 that faces the source region 111 and the side of the first ion injection region 1141 that faces the source region 111 may be set between 0 nm and 25 nm.

During production, an angle between an injection direction of the second ion and a normal of the semiconductor substrate is greater than 0 degrees, so that in the first LDD region, the side of the second ion injection region that faces the drain region extends towards the drain region relative to the side of the first ion injection region that faces the drain region; and in the second LDD region, the side of the second ion injection region that faces the source region extends towards the source region relative to the side of the first ion injection region that faces the source region.

For example, the angle between the injection direction of the second ion and the normal of the semiconductor substrate is set to be greater than or equal to 10 degrees and less than or equal to 60 degrees.

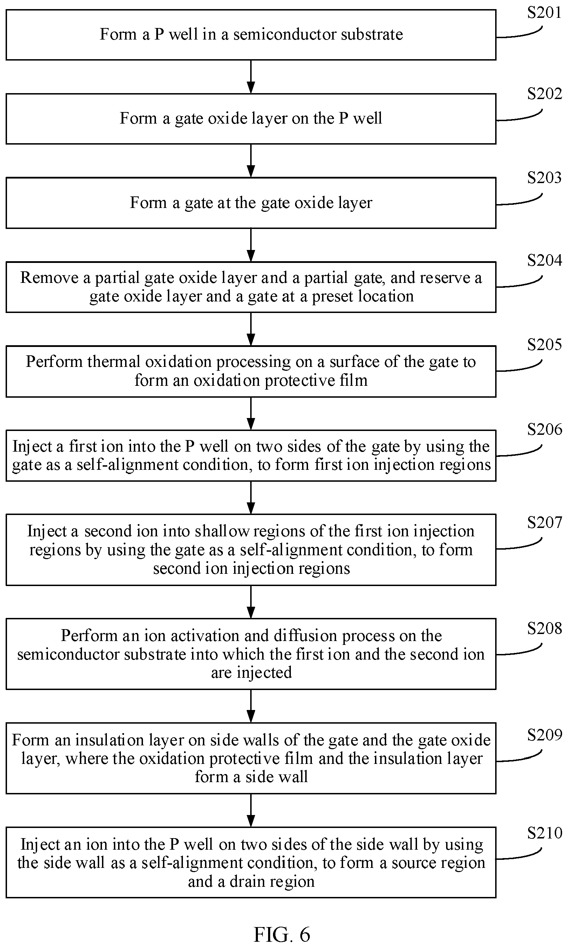

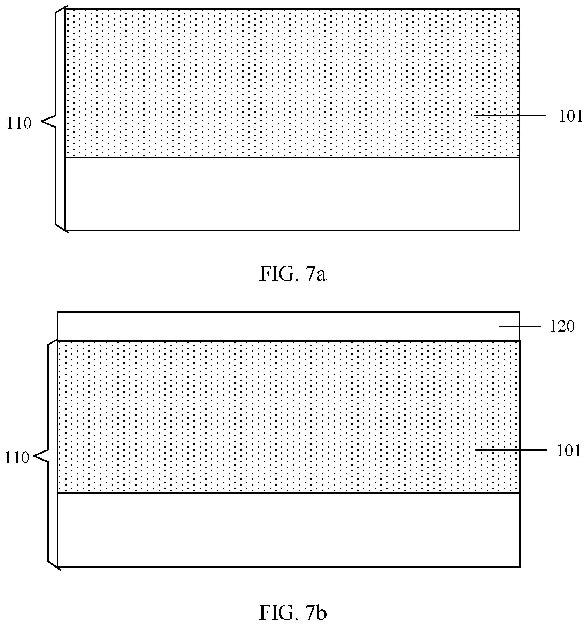

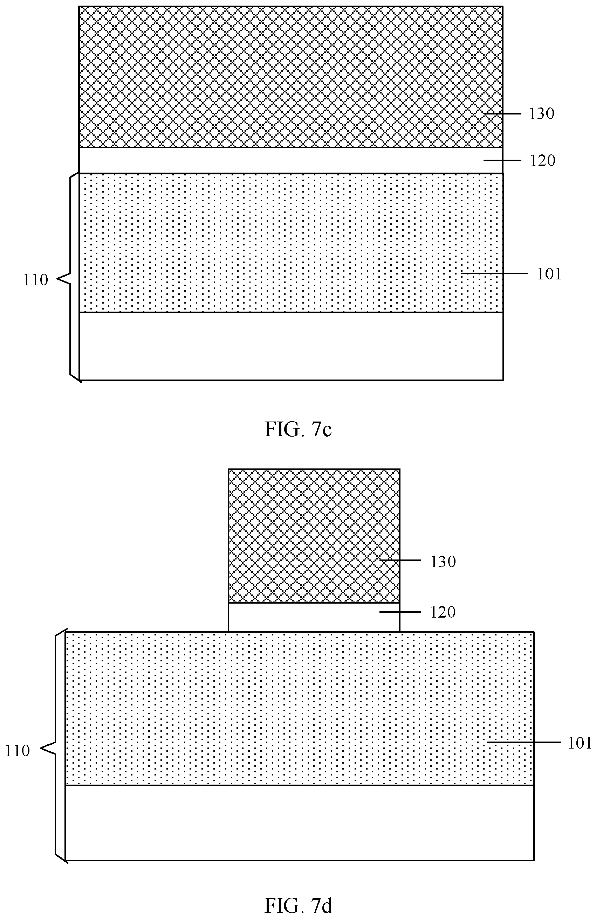

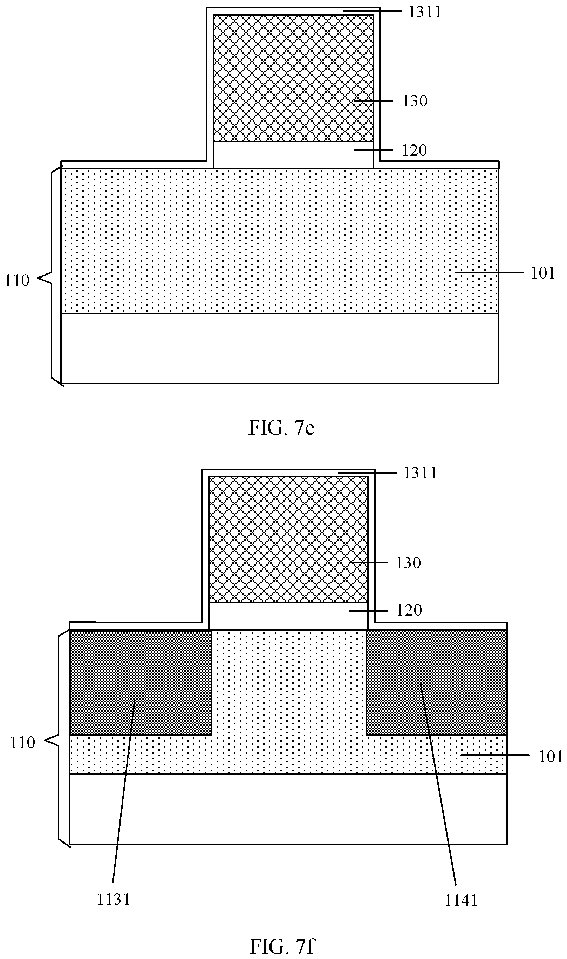

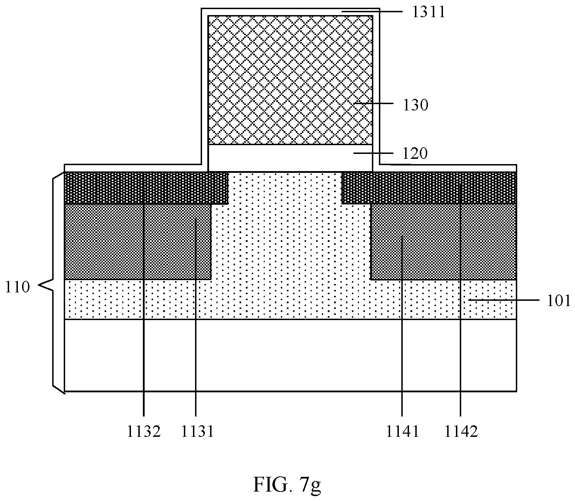

To facilitate understanding of the NMOS device provided in the embodiments of this application, the following describes in detail the production method of the NMOS device with reference to the accompanying drawings. In an embodiment of this application, the NMOS device may be produced by using the following production method. Referring to FIG. 6, with reference to FIG. 7a to FIG. 7i, FIG. 6 is a schematic flowchart of a production method of a field effect transistor according to an embodiment of this application. The method includes the following steps.
Step S201: Form a P well 101 in a semiconductor substrate 110 to form a structure shown in FIG. 7a.
Step S202: Form a gate oxide layer 120 on the P well 101 to form a structure shown in FIG. 7b.
Step S203: Form a gate 130 at the gate oxide layer 120 to form a structure shown in FIG. 7c.
Step S204: Remove a partial gate oxide layer 120 and a partial gate 130, and reserve a gate oxide layer 120 and a gate 130 at a preset location, to form a structure shown in FIG. 7d.
Step S205: Perform thermal oxidation processing on a surface of the gate 130 to form an oxidation protective film 1311, so as to form a structure shown in FIG. 7e.
Step S206: Inject a first ion into the P well 101 on two sides of the gate 130 by using the gate 130 as a self-alignment condition, to form first ion injection regions 1131 and 1141, so as to form a structure shown in FIG. 7f.
Step S207: Separately inject a second ion into shallow regions of the first ion injection regions 1131 and 1141 by using the gate 130 as a self-alignment condition, to form second ion injection regions 1132 and 1142, so as to form a structure shown in FIG. 7g.

For example, an angle between an injection direction of the second ion and a normal of the semiconductor substrate is set to be greater than or equal to 10 degrees and less than or equal to 60 degrees.

Step S208: Perform an ion activation and diffusion process on the semiconductor substrate 110 into which the first ion and the second ion are injected.

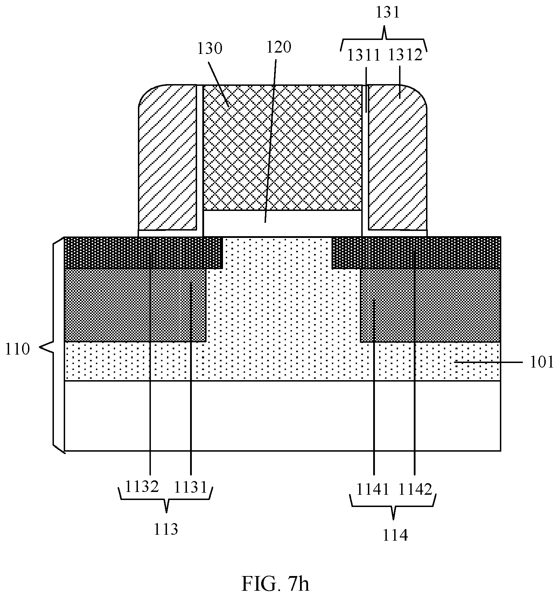

Step S209: Form an insulation layer 1312 on side walls of the gate 130 and the gate oxide layer 120, where the oxidation protective film 1311 and the insulation layer 1312 form a side wall 131, to form a structure shown in FIG. 7h.

For example, the oxidation protective film 1311 and the insulation layer 1312 may be formed by using a material such as silicon oxide or silicon nitride. Materials of the oxidation protective film 1311 and the insulation layer 1312 may be the same or different. This is not limited herein.

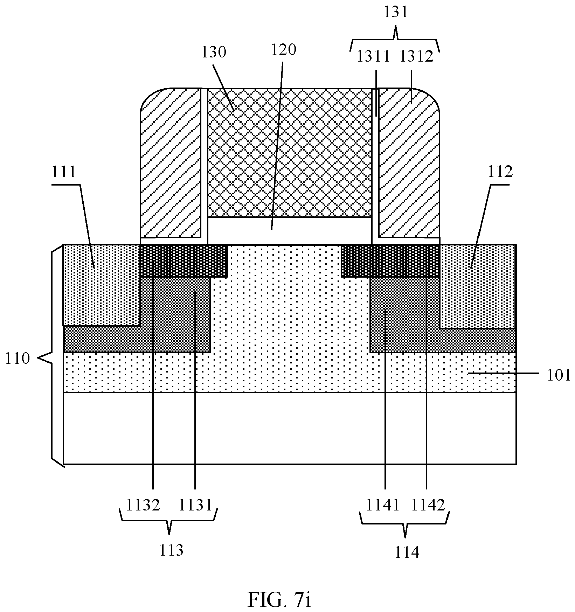

Step S210: Inject an ion into the P well 101 on two sides of the side wall 131 by using the side wall 131 as a self-alignment condition, to form a source region 111 and a drain region 112, so as to form a structure shown in FIG. 7i.

In this application, step S207 is added, so that the second ion is separately injected into the shallow regions of the first ion injection regions 1131 and 1141 to form the second ion injection regions 1132 and 1142. Because the second ion injected into the second ion injection regions 1132 and 1142 is a Ge ion, and an atom of the Ge ion is relatively large, a defect may be generated, to help diffuse the first ion, so that a junction depth becomes deeper and is slowed down, a transverse electric field can be reduced, and an HCI effect can be improved. In addition, the Ge atom may occupy a location of a silicon lattice. Moreover, because the Ge atom is relatively large, a probability that a carrier collides with the Ge atom increases, a mean free path of the carrier decreases, and an energy of the carrier decreases, so that an impact ionization rate can be reduced, a quantity of high-energy carriers can be reduced, and the HCI effect can be further improved. In addition, because the second ion is directly injected after the first ion is injected, and a same photomask may be used to inject the first ion and the second ion, no additional photomask needs to be added. In addition, the ion activation and diffusion process is simultaneously performed on the first ion injection region and the second ion injection region, and no additional ion activation and diffusion process needs to be added for the second ion. Therefore, a process procedure is simpler and costs are lower.

It should be noted that, in this application, a process used in a step other than step S207 is not limited, and may be any well-known method.

Based on a same technical concept, an embodiment of this application further provides an integrated circuit, including a main board and any NMOS device provided in the foregoing embodiments of this application. The NMOS device is disposed on the main board. A principle of resolving a problem by the integrated circuit is similar to that of the foregoing NMOS device. Therefore, for implementation of the integrated circuit, refer to implementation of the foregoing NMOS device. No repeated description is provided.

It is clear that a person skilled in the art can make various modifications and variations to this application without departing from the spirit and scope of this application. This application is intended to cover these modifications and variations of this application provided that they fall within the scope of protection defined by the following claims and their equivalent technologies.

## Claims

1. An NMOS device, comprising:
a semiconductor substrate, wherein the semiconductor substrate comprises a P well, and a source region, a drain region, a first lightly doped drain region, and a second lightly doped drain region that are located in the P well; the first lightly doped drain region is located between the source region and the drain region, and a distance between the first lightly doped drain region and the source region is less than a distance between the first lightly doped drain region and the drain region; and the second lightly doped drain region is located between the source region and the drain region, and a distance between the second lightly doped drain region and the drain region is less than a distance between the second lightly doped drain region and the source region;
a gate oxide layer, wherein the gate oxide layer is located on the P well; and
a gate, wherein the gate is located at the gate oxide layer; and
the first lightly doped drain region and the second lightly doped drain region each comprise a first ion injection region and a second ion injection region; the first ion injection region is formed by injecting a first ion into the P well, and the first ion comprises a phosphorus ion; the second ion injection region is formed by injecting a second ion into the first ion injection region, and the second ion comprises a germanium ion; and an ion injection depth of the first ion injection region is greater than an ion injection depth of the second ion injection region.

2. The NMOS device according to claim 1, wherein the ion injection depth of the second ion injection region is 5 nm to 100 nm.

3. The NMOS device according to claim 1 or 2, wherein an ion injection density of the second ion is 1e14 ions/cm² to 1e15 ions/cm².

4. The NMOS device according to any one of claims 1 to 3, wherein in the first lightly doped drain region, a side of the second ion injection region that faces the drain region extends towards the drain region relative to a side of the first ion injection region that faces the drain region; and
in the second lightly doped drain region, a side of the second ion injection region that faces the source region extends towards the source region relative to a side of the first ion injection region that faces the source region.

5. The NMOS device according to claim 4, wherein in the first lightly doped drain region, a distance between the side of the second ion injection region that faces the drain region and the side of the first ion injection region that faces the drain region is 0 nm to 25 nm; and
in the second lightly doped drain region, a distance between the side of the second ion injection region that faces the source region and the side of the first ion injection region that faces the source region is 0 nm to 25 nm.

6. The NMOS device according to any one of claims 1 to 5, further comprising a side wall located on side walls of the gate and the gate oxide layer.

7. The NMOS device according to any one of claims 1 to 6, wherein the first ion further comprises an arsenic ion.

8. An integrated circuit, comprising a main board and the NMOS device according to any one of claims 1 to 7 disposed on the main board.

9. A production method of an NMOS device, comprising:
providing a semiconductor substrate, wherein the semiconductor substrate has a P well;
forming a gate oxide layer on the P well;
forming a gate at the gate oxide layer; and
forming a source region, a drain region, a first lightly doped drain region, and a second lightly doped drain region in the P well, wherein
the first lightly doped drain region is located between the source region and the drain region, and a distance between the first lightly doped drain region and the source region is less than a distance between the first lightly doped drain region and the drain region; the second lightly doped drain region is located between the source region and the drain region, and a distance between the second lightly doped drain region and the drain region is less than a distance between the second lightly doped drain region and the source region; the first lightly doped drain region and the second lightly doped drain region each comprise a first ion injection region and a second ion injection region; the first ion injection region is formed by injecting a first ion into the P well, and the first ion comprises a phosphorus ion; the second ion injection region is formed by injecting a second ion into the first ion injection region, and the second ion comprises a germanium ion; and an ion injection depth of the first ion injection region is greater than an ion injection depth of the second ion injection region.

10. The production method according to claim 9, wherein the forming a first lightly doped drain region and a second lightly doped drain region in the P well comprises:
injecting the first ion into the P well to form the first ion injection region of the first lightly doped drain region and the first ion injection region of the second lightly doped drain region, wherein the first ion comprises a phosphorus ion or a phosphorus ion and an arsenic ion; and
injecting the second ion into the first ion injection region of the first lightly doped drain region to form the second ion injection region of the first lightly doped drain region, and injecting the second ion into the first ion injection region of the second lightly doped drain region to form the second ion injection region of the second lightly doped drain region, wherein the second ion comprises a germanium ion, and the ion injection depth of the first ion injection region is greater than the ion injection depth of the second ion injection region.

11. The production method according to claim 9 or 10, wherein the ion injection depth of the second ion injection region is 5 nm to 100 nm.

12. The production method according to any one of claims 9 to 11, wherein ion injection energy of the second ion is 10 kev to 60 kev.

13. The production method according to any one of claims 9 to 12, wherein an ion injection density of the second ion is 1e14 ions/cm² to 1e15 ions/cm².

14. The production method according to any one of claims 9 to 13, wherein an angle between an injection direction of the second ion and a normal of the semiconductor substrate is greater than 0 degrees, so that in the first lightly doped drain region, a side of the second ion injection region that faces the drain region extends towards the drain region relative to a side of the first ion injection region that faces the drain region; and in the second lightly doped drain region, a side of the second ion injection region that faces the source region extends towards the source region relative to a side of the first ion injection region that faces the source region.

15. The production method according to claim 14, wherein in the first lightly doped drain region, a distance between the side of the second ion injection region that faces the drain region and the side of the first ion injection region that faces the drain region is 0 nm to 25 nm; and
in the second lightly doped drain region, a distance between the side of the second ion injection region that faces the source region and the side of the first ion injection region that faces the source region is 0 nm to 25 nm.
